# EUROPÄISCHE PATENTSCHRIFT

(11) **EP 3 853 623 B1**
(45) Veröffentlichungstag und Bekanntmachung des Hinweises auf die Patenterteilung: **27.07.2022**
(21) Anmeldenummer: 19786493.7
(22) Anmeldetag: 01.10.2019
(51) Int. Cl.: G01R 31/00, B60L 53/14, B60L 58/12

(54) **BATTERIEÜBERWACHUNGSVERFAHREN BEI EINEM SCHIENENFAHRZEUG**
BATTERY MONITORING PROCESS IN A RAIL VEHICLE
PROCÉDÉ DE CONTRÔLE DE BATTERIE SUR UN VÉHICULE FERROVIAIRE

(30) Priorität: 16.10.2018 DE 102018217700
(43) Veröffentlichungstag der Anmeldung: 28.07.2021
(73) Patentinhaber: Siemens Mobility GmbH, 81739 München (DE)
(72) Erfinder: LOHNEIS, Georg, 96250 Ebensfeld (DE)
(86) Internationale Anmeldenummer: PCT/EP2019/076546
(87) Internationale Veröffentlichungsnummer: WO 2020/078712

(56) Entgegenhaltungen:
- DE-A1-102008 017 685
- DE-A1-102013 201 494
- DE-A1-102015 112 773

## Beschreibung

Die Erfindung betrifft ein Verfahren zur Überwachung der Bordbatterie eines Schienenfahrzeugs.

Bei Schienenfahrzeugen sind unterschiedliche Antriebsarten bekannt, die singulär oder in Mischformen im Schienenfahrzeug realisiert sind und dieses antreiben.

Beispielsweise wird ein Schienenfahrzeug, das über einen Stromabnehmer bzw. Pantographen verfügt, entlang einer Fahrstrecke über einen dort montierten stromführenden Leiter mit elektrischer Energie versorgt. Die Energie gelangt vom Leiter über den Stromabnehmer zum Elektroantrieb und zu elektrisch betriebenen Anlagen des Schienenfahrzeugs.

Um ein Schienenfahrzeug mit Stromabnehmer in Betrieb zu nehmen, ist es notwendig, den Stromabnehmer bzw. Pantographen zu heben, so dass er den stromführenden Leiter kontaktiert. Zu diesem Zweck wird eine seitens des Schienenfahrzeugs vorgesehene und dort angeordnete Bordbatterie verwendet.

Auch mit Diesel betriebene Schienenfahrzeuge verfügen über eine Bordbatterie, mit der bei der Inbetriebnahme des Schienenfahrzeugs über den Anlasser der Dieselmotor gestartet wird, der dann den Antrieb übernimmt.

Sogenannte Elektrolokomotiven werden als Schienenfahrzeuge über eine Bordbatterie und einem damit verbundenen Elektromotor in Betrieb genommen und angetrieben.

In den beispielhaften Fällen sowie in weiteren Antriebsmischformen wird also stets eine Bordbatterie benötigt. Falls die Bordbatterie über eine unzureichende Kapazität verfügt, ist die Inbetriebnahme des Schienenfahrzeugs nicht möglich.

Um dies zu vermeiden, ist an Schienenfahrzeugen eine sogenannte Fremdeinspeisung vorgesehen. Über diese wird das Schienenfahrzeug mit benötigter elektrischer Energie versorgt, falls die Bordbatterie aufgrund eines Kapazitätsmangels ihrer Funktion nicht nachkommen kann.

Die Kapazität der Bordbatterie ist abhängig von vielen Einflussfaktoren - beispielsweise vom Alter der Batterie, vom Ladezustand der Batterie beim Abstellen des Schienenfahrzeugs, von einer systembedingten (Selbst-) Entladung der Batterie über einen Zeitraum, von einer Batterie-Außentemperatur und damit letztlich auch vom Wetter bzw. von der Jahreszeit.

Es ist bekannt, bei einer Bordbatterie einen Unterspannungsschutz vorzusehen: falls die Spannung der Batterie und damit deren Kapazität zu gering ist, löst der Unterspannungsschutz aus. In Folge werden elektrische Verbraucher von der Batterie getrennt und die Bordbatterie wird damit vor den Folgen einer Tiefentladung geschützt.

Der Unterspannungsschutz kann jedoch nicht die systembedingte Selbstentladung der Bordbatterie verhindern, so dass die Bordbatterie trotz getrennter elektrischer Verbraucher nach einer bestimmten Zeit tiefentladen wird, mit allen negativen und bekannten Konsequenzen für deren Lebensdauer.

Um sicherzustellen, dass die Bordbatterie trotz Selbstentladung genügend Kapazität für eine Inbetriebnahme des Schienenfahrzeugs aufweist, wird der Ladezustand der Bordbatterie bei abgestellten Schienenfahrzeugen periodisch wiederkehrend (beispielsweise stündlich, täglich, etc.) überwacht. Betriebspersonal bestimmt die Säuredichte der Bordbatterie regelmäßig, um deren Kapazität zu überwachen. Dies ist zeitaufwändig und der Erfolg ist abhängig vom gewählten Zeitintervall sowie von der Sorgfalt und dem Können des Betriebspersonals.

Aus der Druckschrift DE 10 2015112 773 A1 ist ein Verfahren zum Betreiben eines automatisch geführten Wagens bekannt. Der Wagen wird unter Verwendung eines Controllers auf einer Produktionsbetriebsstrecke geleitet. Ein Ladezustand in einem bordeigenen Batteriestapel wird automatisch detektiert und an eine entfernte Station signalisiert. Wenn der Ladezustand unter einer vorbestimmten Ladungsgrenze liegt, wird dem Wagen automatisch signalisiert, automatisch aus der Produktionsbetriebsstrecke auf eine Strecke für niedrige Batterieladung abzudrehen und an einer Batteriestation anzuhalten. Auf dieser Strecke für niedrige Batterieladung erfolgt ein Austausch des Batteriestapels durch dafür alarmierte Fabrikarbeiter.

Es ist die Aufgabe der vorliegenden Erfindung, ein verbessertes Verfahren zur Bordbatterieüberwachung bei einem Schienenfahrzeug anzugeben, das mit geringem Aufwand kostengünstig und zuverlässig ausführbar ist und das eine Tiefentladung der Bordbatterie des Schienenfahrzeugs vermeidet.

Diese Aufgabe wird durch die Merkmale des Anspruchs 1 gelöst. Vorteilhafte Weiterbildungen sind in den weiteren Ansprüchen angegeben.

Die Erfindung betrifft ein Verfahren zur Überwachung der Bordbatterie eines Schienenfahrzeugs. Der Ladezustand der Bordbatterie wird regelmäßig wiederkehrend und automatisiert ermittelt. Der Ladezustand wird regelmäßig mit einem vorgegebenen, vorbestimmten Ladezustand-Sollwert verglichen. Unterschreitet der ermittelte Ladezustand der Bordbatterie den Ladezustand-Sollwert, wird eine Meldung generiert, durch die Maßnahmen zum Laden der Bordbatterie eingeleitet werden.

Die Meldung zum niedrigen Ladezustand der Bordbatterie kann, wie nachfolgend beschrieben, seitens einer Kontrollstelle oder seitens des Schienenfahrzeugs gebildet werden.

Erfindungsgemäß wird der ermittelte Ladezustand regelmäßig an eine Kontrollstelle übermittelt und dort mit dem Ladezustand-Sollwert verglichen.

In einer bevorzugten Weiterbildung der Erfindung wird der ermittelte Ladezustand über eine Funkschnittstelle bzw. über eine Funkverbindung vom Schienenfahrzeug an die Kontrollstelle übertragen.

In einer bevorzugten Weiterbildung der Erfindung wird der Ladezustand der Bordbatterie zusammen mit weiteren Informationen des Schienenfahrzeugs an die Kontrollstelle übertragen. Bevorzugt handelt es sich dabei um folgende Informationen:
- Fahrzeugnummer des Schienenfahrzeugs, und/oder
- Datum bzw. Uhrzeit, die dem ermittelten Ladezustand zuordenbar sind, und/oder
- eine aktuelle Positionsangabe des Schienenfahrzeugs,
- etc.

Diese Informationen werden seitens der Kontrollstelle angezeigt, um dort eine kontinuierliche Kontrolle und Übersicht zu ermöglichen.

In einer bevorzugten Weiterbildung der Erfindung wird der Ladezustand der Bordbatterie über eine Spannungsmessung bestimmt, die bevorzugt an den Polen der Bordbatterie durchgeführt wird.

Erfindungsgemäß ist die Kontrollstelle eine sogenannte "andseitige", d.h. räumlich zum Schienenfahrzeug entfernte, ortsfeste Kontroll- bzw. Leitstelle.

Erfindungsgemäß wird die Meldung seitens der Kontrollstelle generiert und an das betroffene Schienenfahrzeug zurückübertragen.

Diese Übertragung erfolgt bevorzugt ebenfalls über eine Funkschnittstelle bzw. Funkverbindung von der Kontrollstelle zum Schienenfahrzeug.

In einer bevorzugten Weiterbildung der Erfindung wird eine Vollzugsmeldung an die Kontrollstelle gesendet, sobald die Bordbatterie den gewünschten Ladezustand erreicht hat.

In einer bevorzugten Weiterbildung der Erfindung wird nach erfolgter Beendigung des Ladevorgangs der aktuelle Ladezustand der Bordbatterie an die Kontrollstelle übertragen.

In einer bevorzugten Weiterbildung der Erfindung wird die Ermittlung des Ladezustands der Bordbatterie in Abhängigkeit des aktuellen Wetters bzw. in Abhängigkeit einer Wettervorhersage durchgeführt.

Damit ist es möglich, die Ladezustands-Überwachung bzw. deren Regelmäßigkeit in Abhängigkeit von gemessenen bzw. von erwarteten Temperaturen durchzuführen und diese somit zeitlich sinnvoll zu gestalten.

Damit wird auch ermöglicht, dass bei einem vorhergesagten Kälteeinbruch ein vorbeugendes Laden der Bordbatterie erfolgt.

Erfindungsgemäß veranlasst die generierte Meldung bei einem abgestellten Schienenfahrzeug mit Stromabnehmer ein Anheben des Stromabnehmers sowie ein Aktivieren von Komponenten, die zum Laden der Bordbatterie benötigt werden. Dieses Anheben erfolgt mit Hilfe der Energie, die in der Bordbatterie (noch) gespeichert und vorhanden ist. Der Stromabnehmer kontaktiert den stromführenden Leiter, so dass die Bordbatterie des Schienenfahrzeugs aufgeladen wird.

Erfindungsgemäß wird der Stromabnehmer wieder abgesenkt und das Aufladen der Bordbatterie beendet, sobald die Bordbatterie den gewünschten Ladezustand erreicht hat. Entsprechend werden dann die Komponenten, die zum Laden der Bordbatterie benötigt wurden, wieder deaktiviert.

Die Meldung zum niedrigen Ladezustand der Bordbatterie kann durch Vergleich, wie vorstehend beschrieben, also seitens der Kontrollstelle gebildet werden.

Durch die vorliegende Erfindung wird eine Selbst- bzw. eine Tiefentladung der Batterie zuverlässig vermieden.

Durch die vorliegende Erfindung wird sichergestellt, dass das Schienenfahrzeug in jeder Bordbatterie-Situation betriebsbereit ist.

Durch die vorliegende Erfindung werden Personalkosten reduziert: bislang benötigte periodische Messungen der Säuredichte der Bordbatterie durch Betriebspersonal können reduziert oder gänzlich eingespart werden.

Nachfolgend wird die vorliegende Erfindung beispielhaft anhand einer Zeichnung näher erläutert. Dabei zeigt:
- FIG 1: das Prinzip des erfindungsgemäßen Verfahrens anhand eines ersten Blockschaltbilds, und
- FIG 2: mit Bezug auf FIG 1 eine vorteilhafte Weiterbildung des erfindungsgemäßen Verfahrens anhand eines zweiten Blockschaltbilds.

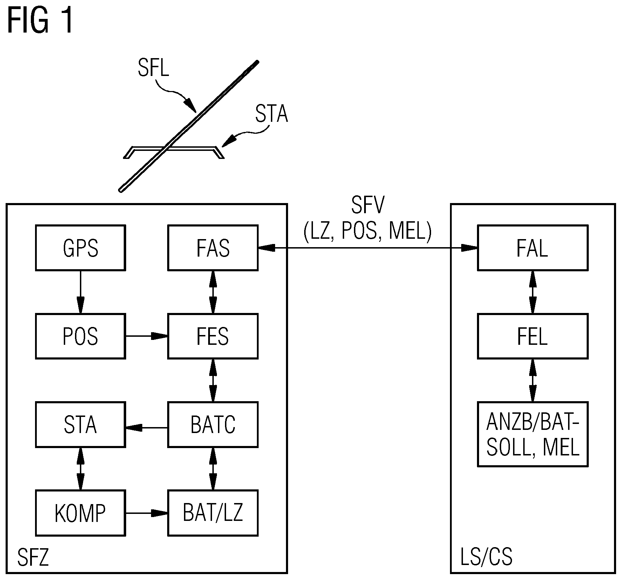

FIG 1 zeigt das Prinzip des erfindungsgemäßen Verfahrens anhand eines ersten Blockschaltbilds.

Ein Schienenfahrzeugs SFZ weist eine Bordbatterie BAT auf, deren Ladezustand LZ überwacht werden soll.

Der Ladezustand LZ der Bordbatterie BAT wird regelmäßig wiederkehrend und automatisiert mit Hilfe einer Batterieüberwachung BATC ermittelt.

Der ermittelte Ladezustand LZ wird mit Hilfe einer Schienenfahrzeug-seitigen Funkeinheit FES und mit Hilfe einer Schienenfahrzeug-seitigen Funkantenne FAS an eine Landseite LS bzw. Kontrollstelle CS übertragen.

Die Übertragung zwischen dem Schienenfahrzeug SFZ einerseits und der landseitigen Kontrollstelle CS andererseits erfolgt über eine sichere Funkverbindung SFV.

Seitens des Schienenfahrzeugs SFZ wird mit Hilfe eines GPS-Systems GPS eine Positionsinformation POS gewonnen und zusammen mit dem Ladezustand LZ an die landseitige Kontrollstelle CS übertragen. Diese Übertragung erfolgt unter Nutzung Schienenfahrzeug-seitigen Funkeinheit FES, der Schienenfahrzeugseitigen Funkantenne FAS und der sicheren Funkverbindung SFV.

Die landseitige Kontrollstelle CS verfügt über eine landseitige Funkantenne FAL und über eine landseitige Funkeinheit FEL, die der Funkantenne FAL nachgeschaltet ist. Mit deren Hilfe werden die Informationen bezüglich der Position POS und des Ladezustands LZ landseitig empfangen und an eine Anzeige ANZB weitergegeben.

Mit Hilfe der Anzeige ANZB wird der Ladezustand LZ der Bordbatterie BAT mit einem regelmäßig mit einem vorgegebenen, vorbestimmten Ladezustand-Sollwert BAT-SOLL verglichen.

Unterschreitet der ermittelte Ladezustand LZ der Bordbatterie BAT den Ladezustand-Sollwert BAT-SOLL, wird eine Meldung MEL generiert und an der Anzeige ANZB angezeigt.

Durch die Meldung MEL werden Maßnahmen zum Laden der Bordbatterie BAT wie nachfolgend beschrieben eingeleitet:
Die Meldung MEL wird seitens der Kontrollstelle CS an das betroffene Schienenfahrzeug SFZ zurückübertragen, wobei diese Übertagung die folgenden Komponenten ebenfalls benutzt:
- landseitige Funkeinheit FEL,
- landseitige Funkantenne FA,
- sichere Funkverbindung SFV,
- Schienenfahrzeug-seitige Funkantenne FAS, und
- Schienenfahrzeug-seitige Funkeinheit FES.

Seitens des Schienenfahrzeugs SFZ wird durch die Meldung MEL veranlasst, dass beim abgestellten Schienenfahrzeug SFZ ein Stromabnehmer STA angehoben wird, bis er einen stromführenden Leiter SFL kontaktiert. Entsprechend werden Komponenten KOMP des Schienenfahrzeugs SFZ aktiviert, die zum Laden der Bordbatterie BAT benötigt werden.

Die Bordbatterie BAT des Schienenfahrzeugs SFZ wird aufgeladen und der jeweilige Ladezustand LZ wird wie oben beschrieben kontinuierlich überwacht und an die landseitige Kontrollstelle CS übermittelt.

Über den landseitigen Vergleich zwischen dem jeweiligen Ladezustand LZ der Bordbatterie BAT mit dem Ladezustand-Sollwert BAT-SOLL wird wieder eine Meldung MEL generiert, sobald das Aufladen der Bordbatterie BAT erfolgt ist.

Über die zurückübertragene Meldung MEL wird seitens des Schienenfahrzeugs SFZ dann ein Absenken des Stromabnehmers STA veranlasst und die Komponenten KOMP, die zum Laden der Bordbatterie BAT benötigt wurden, werden entsprechend deaktiviert. Damit ist das Aufladen der Bordbatterie BAT beendet.

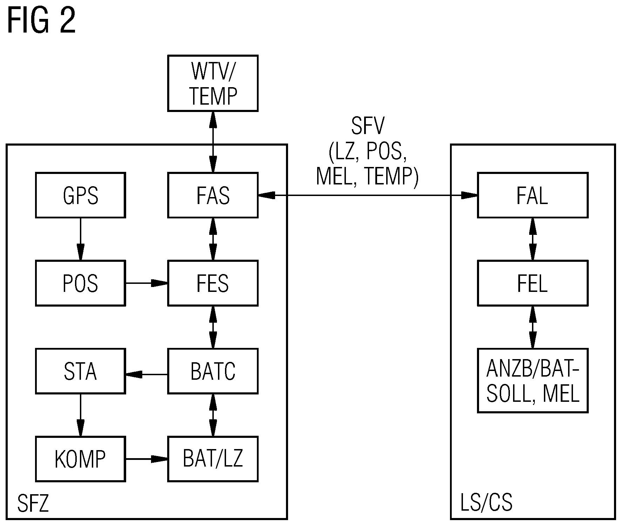

FIG 2 zeigt mit Bezug auf FIG 1 eine vorteilhafte Weiterbildung des erfindungsgemäßen Verfahrens anhand eines zweiten Blockschaltbilds.

Hier wird die Ermittlung des Ladezustands LZ der Bordbatterie BAT in Abhängigkeit des aktuellen Wetters durchgeführt. Dadurch wird eine Ladezustands-Überwachung realisiert, die in Abhängigkeit von gemessenen bzw. von erwarteten Temperaturen erfolgt.

In diesem Beispiel wird seitens des Schienenfahrzeugs SFZ die aktuelle Temperatur TEMP über eine Einrichtung zur Wettervorhersage WTV gemessen.

Bei einem vorhergesagten bzw. hier detektierten Kälteeinbruch wird ein vorbeugendes Laden der Bordbatterie BAT initialisiert.

Beispielweise wird dazu die Temperatur TEMP an die landseitige Kontrollstelle CS als zusätzliche Information übermittelt und bei der Generierung der Meldung MEL zusätzlich berücksichtigt. Beispielsweise wird die Meldung MEL zum Laden der Bordbatterie BAT bei kühlen bzw. niedrigen Temperaturen TEMP früher initialisiert und zurückübertragen als bei normalen bzw. höheren Temperaturen TEMP.

## Patentansprüche

1. Verfahren zur Überwachung der Bordbatterie eines Schienenfahrzeugs,
- bei dem der Ladezustand der Bordbatterie eines abgestellten Schienenfahrzeugs regelmäßig wiederkehrend und automatisiert ermittelt wird,
- bei dem der ermittelte Ladezustand regelmäßig an eine Kontrollstelle übertragen wird,
- bei dem die Kontrollstelle den ermittelten Ladezustand regelmäßig mit einem Ladezustand-Sollwert vergleicht und eine Meldung bei einem Unterschreiten des Ladezustand-Sollwert generiert, durch die Maßnahmen zum Laden der Bordbatterie eingeleitet werden,
- wobei die Kontrollstelle eine landseitige, d.h. räumlich zum Schienenfahrzeug entfernte, ortsfeste Kontroll- bzw. Leitstelle ist,
- bei dem die seitens der Kontrollstelle generierte Meldung an das betroffene Schienenfahrzeug zurückübertragen wird,
- bei dem die generierte Meldung beim abgestellten Schienenfahrzeug mit Stromabnehmer ein automatisches Anheben des Stromabnehmers sowie ein automatisches Aktivieren von Komponenten, die zum Laden der Bordbatterie benötigt werden, veranlasst, um die Bordbatterie zu laden, und
- bei dem der Stromabnehmer wieder abgesenkt und das Aufladen der Bordbatterie beendet wird, sobald die Bordbatterie einen gewünschten Ladezustand erreicht hat, wobei dann die Komponenten, die zum Laden der Bordbatterie benötigt wurden, wieder deaktiviert werden.

2. Verfahren nach Anspruch 1, bei dem die Übertragungen über eine Funkverbindung erfolgen, die zwischen dem Schienenfahrzeug und der Kontrollstelle eingerichtet ist.

3. Verfahren nach Anspruch 1, bei dem eine Information zum Ladezustand der Bordbatterie zusammen mit einer weiteren Information des Schienenfahrzeugs an die Kontrollstelle übertragen wird, wobei diese Information zumindest eine der folgenden Angaben enthält:
- eine Fahrzeugnummer des Schienenfahrzeugs, und/oder
- Datum bzw. Uhrzeit, die dem ermittelten Ladezustand zugeordnet sind, und/oder
- eine aktuelle Positionsangabe des Schienenfahrzeugs.

4. Verfahren nach Anspruch 3, bei dem die Informationen seitens der Kontrollstelle angezeigt werden, um dort eine kontinuierliche Kontrolle und Übersicht bezüglich des Ladezustands eines ausgewählten Schienenfahrzeugs zu realisieren.

5. Verfahren nach einem der vorhergehenden Ansprüche, bei dem vom Schienenfahrzeug eine Vollzugsmeldung an eine Kontrollstelle gesendet wird, sobald die Bordbatterie den gewünschten Ladezustand erreicht hat.

6. Verfahren nach einem der vorhergehenden Ansprüche, bei dem die Ermittlung des Ladezustands der Bordbatterie in Abhängigkeit des aktuellen Wetters bzw. in Abhängigkeit einer Wettervorhersage durchgeführt wird.

7. Verfahren nach einem der vorhergehenden Ansprüche, bei dem der Ladezustand der Bordbatterie über eine Spannungsmessung bestimmt wird, die an den Polen der Bordbatterie durchgeführt wird.

## Claims

1. Method for monitoring the on-board battery of a rail vehicle,
- in which the state of charge of the on-board battery of a switched-off rail vehicle is determined in a regularly recurring and automated manner,
- in which the determined state of charge is regularly transmitted to a control station,
- in which the control station regularly compares the determined state of charge with a state of charge target value and generates a message if the state of charge target value is undershot, which message initiates measures for charging the on-board battery,
- wherein the control station is a land-side stationary control station, that is to say a control station which is spatially remote from the rail vehicle,
- in which the message generated by the control station is transmitted back to the affected rail vehicle,
- in which, in the case of the switched-off rail vehicle with a pantograph, the generated message causes automatic raising of the pantograph and automatic activation of components which are needed to charge the on-board battery, in order to charge the on-board battery, and
- in which the pantograph is lowered again and the charging of the on-board battery is terminated as soon as the on-board battery has reached a desired state of charge, wherein the components which were needed to charge the on-board battery are then deactivated again.

2. Method according to Claim 1, in which the transmissions are effected via a radio connection which is set up between the rail vehicle and the control station.

3. Method according to Claim 1, in which an item of information relating to the state of charge of the on-board battery is transmitted, together with a further item of information relating to the rail vehicle, to the control station, wherein this information at least contains one of the following details:
- a vehicle number of the rail vehicle, and/or
- a date and time which are assigned to the determined state of charge, and/or
- a current position indication of the rail vehicle.

4. Method according to Claim 3, in which the information is displayed by the control station in order to implement continuous control and an overview of the state of charge of a selected rail vehicle there.

5. Method according to one of the preceding claims, in which a completion message is transmitted from the rail vehicle to a control station as soon as the on-board battery has reached the desired state of charge.

6. Method according to one of the preceding claims, in which the state of charge of the on-board battery is determined on the basis of the current weather or on the basis of a weather forecast.

7. Method according to one of the preceding claims, in which the state of charge of the on-board battery is determined by means of a voltage measurement which is carried out at the poles of the on-board battery.

## Revendications

1. Procédé de contrôle de la batterie de bord d'un véhicule ferroviaire,
- dans lequel l'état de charge de la batterie de bord d'un véhicule ferroviaire en stationnement est déterminé de manière récurrente et automatisée,
- dans lequel l'état de charge déterminé est régulièrement transmis à un poste de contrôle,
- dans lequel le poste de contrôle compare régulièrement l'état de charge déterminé avec une valeur d'état de charge nominale et génère un message si la valeur d'état de charge nominale tombe en dessous, par lequel des mesures de charge de la batterie de bord sont introduites,
- dans lequel le poste de contrôle est un poste de contrôle ou poste de commande stationnaire, c'est-à-dire physiquement éloigné du véhicule ferroviaire,
- dans lequel le message généré par le poste de contrôle est retransmis au véhicule ferroviaire concerné,
- dans lequel le message généré lors du stationnement du véhicule ferroviaire à pantographe provoque le soulèvement automatique du pantographe et l'activation automatique des composants nécessaires à la charge de la batterie de bord pour charger la batterie de bord, et
- dans lequel le pantographe est à nouveau abaissé et la charge de la batterie de bord est terminée dès que la batterie de bord a atteint un niveau de charge souhaité, les composants qui étaient nécessaires pour charger la batterie de bord étant alors à nouveau désactivés.

2. Procédé selon la revendication 1, dans lequel les transmissions s'effectuent via une liaison radio qui est établie entre le véhicule ferroviaire et le poste de contrôle.

3. Procédé selon la revendication 1, dans lequel une information sur l'état de charge de la batterie de bord est transmise au poste de contrôle avec d'autres informations sur le véhicule ferroviaire, cette information contenant au moins l'une des indications suivantes :
- un numéro de véhicule du véhicule ferroviaire, et/ou
- date ou heure associée à l'état de charge déterminé, et/ou
- une position actuelle du véhicule ferroviaire.

4. Procédé selon la revendication 3, dans lequel les informations sont affichées par le poste de contrôle afin d'y réaliser un contrôle et une vue d'ensemble continus concernant l'état de charge d'un véhicule ferroviaire sélectionné.

5. Procédé selon l'une des revendications précédentes, dans lequel le véhicule ferroviaire envoie un message d'achèvement à un poste de contrôle dès que la batterie de bord a atteint le niveau de charge souhaité.

6. Procédé selon l'une des revendications précédentes, dans lequel l'état de charge de la batterie de bord est déterminé en fonction de la météo actuelle ou en fonction d'une prévision météorologique.

7. Procédé selon l'une des revendications précédentes, dans lequel l'état de charge de la batterie de bord est déterminé par une mesure de tension qui est effectuée aux bornes de la batterie de bord.
